# EUROPÄISCHE PATENTANMELDUNG

(11) **EP 1 168 356 A1**
(43) Veröffentlichungstag der Anmeldung: **02.01.2002**
(21) Anmeldenummer: 01114211.4
(22) Anmeldetag: 11.06.2001
(51) Int. Cl.: G11C 11/22, G11C 29/00

(54) **Schaltungsanordnung zum Ausgleich unterschiedlicher Spannungen auf Leitungszügen in integrierten Halbleiterschaltungen**

(30) Priorität: 30.06.2000 DE 10031947
(71) Anmelder: Infineon Technologies AG, 81669 München (DE)
(72) Erfinder: Esterl, Robert, 81827 München (DE); Manyoki, Zoltan, Kanata, ON K2L 3W9 (CA)
(74) Vertreter: Müller . Hoffmann & Partner Patentanwälte

(57) **Zusammenfassung**

Die Erfindung betrifft eine Schaltungsanordnung zum Ausgleich von unterschiedlichen Spannungen auf Leitungszügen in integrierten Halbleiterschaltungen, bei der zwischen der Bitleitung und der Plateleitung ein Spannungsausgleichstransistor vorgesehen ist, der im Normalbetrieb der Halbleiterschaltung durch ein Steuersignal niederohmig schaltbar ist, um die unterschiedlichen Spannungen auf den Leitungen auszugleichen.

## Beschreibung

Schaltungsanordnung zum Ausgleich unterschiedlicher Spannungen auf Leitungszügen in integrierten Halbleiterschaltungen

Die Erfindung betrifft eine Schaltungsanordnung zum Ausgleich einer Differenz zwischen einer Bitleitungsspannung hohen Pegels auf einer Bitleitung und einer Plateleitungsspannung hohen Pegels auf der Plateleitung eines ferroelektrischen RAM-Speichers.

Bislang wird die Schreib- und die Lesespannung auf einer Plateleitung und Bitleitung eines ferroelektrischen RAM-Speichers durch ein Generatorsystem erzeugt, das die Plateleitung und die Bitleitung zu gleichen Teilen versorgt.

Wenn ein solcher Spannungsgenerator eine einzige Ausgangsspannung erzeugt, kann es mit hoher Wahrscheinlichkeit vorkommen, daß die über die getrennten Bitleitungen und Plateleitungen zu mehreren Speicherbänken oder -segmenten verteilten Spannungen an bestimmten Punkten oder bei bestimmten Betriebszuständen der Speicherschaltung differierende Pegel aufweisen, die z. B. im Testmodus detektiert werden können.

DE 691 19 679 T2 beschreibt eine Ausgangsschaltung eines Abfühlverstärkers für einen Halbleiterspeicher. Dabei wird das Ausgangssignal des Halbleiterspeichers kurzzeitig stabil auf einem festgelegten Pegel gehalten, und zwar auch dann, wenn Ausgleichsimpulse, das heißt Signalunsicherheiten, auftreten.

Zu diesem Zweck ist bei der bekannten Ausgangsschaltung ein Transfergatter zwischen zwei gegenphasige Ausgangssignalleitungen geschaltet, das während der kurzen Zeit leitend gemacht wird. Die beiden genannten Ausgangssignalleitungen der bekannten Ausgangsschaltungen führen sonst prinzipiell immer entgegengesetztes Potential, das von zwei komplementär geschalteten Differenzverstärkern erzeugt wird. Demnach sollen bei der bekannten Ausgangsschaltung nicht zwei nominell gleiche Spannungspegel, die eine gewisse Differenz haben können, ausgeglichen werden, sondern kurzzeitig ein mittleres Potential zwischen zwei gegenphasigen Ausgangssignalen erzeugt werden.

Es ist Aufgabe der Erfindung, eine einfache Schaltungsanordnung zum Ausgleich von unterschiedlichen Spannungen auf Leitungszügen in integrierten Halbleiterschaltungen, insbesondere der Bitleitungsspannung hohen Pegels und der Plateleitungsspannung hohen Pegels eines ferroelektrischen RAM-Speichers so anzugeben, daß sich die unterschiedlichen Spannungen (insbesondere Schreib- und Lesespannung) im Normalbetrieb ausgleichen und außerdem im Testmodus unabhängig voneinander bewerten lassen.

Diese Aufgabe wird erfindungsgemäß dadurch gelöst, daß zwischen der Bitleitung und der Plateleitung ein Spannungsausgleichstransistor vorgesehen ist, der im Normalbetrieb der Halbleiterschaltung, während die Schreib- bzw. Lesespannung auf der Bitleitung und der Plateleitung zusammen hohen Pegel haben, durch ein Steuersignal niederohmig schaltbar ist, um die Spannungsdifferenz zwischen der Bitleitung und der Plateleitung auszugleichen.

Der Spannungsausgleichstransistor kompensiert den unterschiedlichen Spannungspegel bei einem ferroelektrischen RAM-Speicher auf der Plate- und Bitleitung und kann im Testmodus hochohmig geschaltet werden, so daß dann ein getrenntes Detektieren der Plate- und Bitleitungsspannungen möglich ist.

Bevorzugt ist der Spannungsausgleichstransistor ein MOS-Transistor, der mit seinem Source- und Drainanschluß jeweils mit der Bitleitung und der Plateleitung verbunden ist und an dessen Gateanschluß das Steuersignal, d. h. im Normalbetrieb das invertierte Testmodesignal, anlegbar ist.

Auf diese Weise ist der Spannungsausgleichstransistor im Testmodus hochohmig schaltbar, so daß im Testmodus eine Trennung der Plate- und Bitleitungsspannung erreicht ist. Dadurch ist bei einem ferroelektrischen RAM-Speicher eine bessere Charakterisierung der ferroelektrischen Speicherzelle möglich.

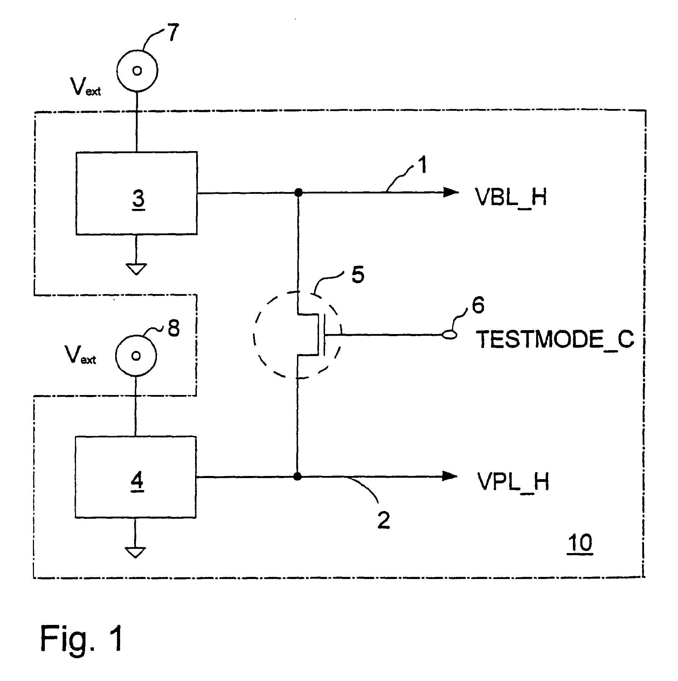

Nachstehend wird ein Ausführungsbeispiel der erfindungsgemäßen Schaltungsanordnung anhand der einzigen Zeichnungsfigur näher beschrieben.

Die Figur zeigt - teilweise als Blockschaltbild - eine in einem integrierten ferroelektrischen RAM-Speicher 10 vorgesehene erfindungsgemäße Schaltungsanordnung. Die über eine Bitleitung 1 zu verteilende Bitleitungsspannung hohen Pegels VBL_H und die über eine Plateleitung 2 zu verteilende Plateleitungsspannung hohen Pegels VPL_H werden von einem VBL_H-Generator 3 und einem davon separaten VPL-Generator 4 separat erzeugt. Der VBL_H-Generator 3 und der VPL-Generator 4 werden von einer externen Spannung Vₑₓₜ 7 und 8 gespeist.

Erfindungsgemäß ist ein Spannungsausgleichstransistor 5 vorgesehen, der im Normalbetrieb eine niederohmige Brücke zwischen der Bitleitung 1 und der Plateleitung 2 bildet und der im Testmodus durch ein seinem Steueranschluß 6 zugeführtes Signal TESTMODE hochohmig schaltbar ist, so daß im Testmodus die Plate- und Bitleitungsspannung getrennt sind. Dadurch lassen sich die Plateleitungsspannung und die Bitleitungsspannung getrennt detektieren und somit die mit der Bitleitung und der Plateleitung verbundene ferroelektrische Speicherzelle (in der Figur nicht gezeigt) besser charakterisieren.

Im Ausführungsbeispiel ist der Spannungsausgleichstransistor ein MOS-Transistor 5, der in der in der Figur dargestellten Weise mit seinem Source- und Drainanschluß jeweils an der Bitleitung 1 und der Plateleitung 2 angeschlossen ist. Der MOS-Transistor 5 erhält an seinem Gateanschluß im Normalbetrieb das invertierte Testmode-Signal TESTMODE-C und wird dadurch niederohmig geschaltet.

## Patentansprüche

1. Schaltungsanordnung zum Ausgleich einer Differenz zwischen einer Bitleitungsspannung (VBL_H) hohen Pegels auf einer Bitleitung (1) und einer Plateleitungsspannung (VPL_H) hohen Pegels auf der Plateleitung (2) eines ferroelektrischen RAM-Speichers (10),
**dadurch gekennzeichnet,**
**daß** zwischen der Bitleitung (1) und der Plateleitung (2) ein Spannungsausgleichstransistor (5) vorgesehen ist, der im Normalbetrieb der Halbleiterschaltung, während die Schreib- bzw. Lesespannung auf der Bitleitung (1) und der Plateleitung (2) zusammen hohen Pegel haben durch ein Steuersignal (6) niederohmig schaltbar ist, um die Spannungsdifferenz zwischen der Bitleitung (1) und der Plateleitung (2) auszugleichen.

2. Schaltungsanordnung nach Anspruch 1,
**dadurch gekennzeichnet,**
**daß** der Spannungsausgleichstransistor (5) ein MOS-Transistor ist, der mit seinem Sourceanschluß und seinem Drainanschluß jeweils an der Bitleitung (1) und der Plateleitung (2) angeschlossen ist und an dessen Gateanschluß das Steuersignal (6) anlegbar ist.

3. Schaltungsanordnung nach Anspruch 1 oder 2,
**dadurch gekennzeichnet,**
**daß** im Falle des ferroelektrischen RAM-Speichers das Steuersignal (6) das invertierte Testmode-Signal (TESTMODE-C) ist.

4. Schaltungsanordnung nach einem der vorangehenden Ansprüche,
**dadurch gekennzeichnet,**
**daß** der Spannungsausgleichstransistor (5) im Testmodus, wenn kein Normalbetrieb herrscht, durch das wahre Testmode-Signal hochohmig schaltbar ist.
